# EUROPEAN PATENT APPLICATION

(11) **EP 1 944 663 A1**
(43) Date of publication of application: **16.07.2008**
(21) Application number: 08100233.9
(22) Date of filing: 09.01.2008
(51) Int. Cl.: G05B 17/02, G05B 13/04, G06F 9/455, G05B 23/02

(54) **Systems and methods for turbine control simulation**

(30) Priority: 10.01.2007 US 621836
(71) Applicant: General Electric Company, Schenectady, NY 12345 (US)
(72) Inventor: Boggs, Kenneth Warren, Roanoke, VA 24019 (US); Ahmed, Anwar, Salem, VA 24153 (US); Minto, Karl Dean, Ballston Lake, NY 12019 (US); Udupa, Chetan Sooryanarayan, 574211, Karnataka (D.K.) (IN); Synard, Clayton Joseph, Simpsonville, SC 29681 (US); Balagopalan, P.K., 560037, Karnataka (IN); Gopalakrishna, Sandeep, 560037, Bangalore (IN); Morton, Gregory John, Salem, VA 21453 (US)
(74) Representative: Bedford, Grant Richard

(57) **Abstract**

Systems and methods for simulating dynamic feedback control systems that include establishing a connection via a common access to a shared memory (112) between the control system logic (106) of a controller to be emulated (104) and a simulation model (114). State data from a previous simulation associated with the control system logic (106) and the simulation model (114) is retrieved from memory to initialize another simulation run. The state data associated with the simulation model (114) and the control system logic (106) are then synchronized with a timing and control mechanism (116) and a simulation of the controller is executed. A graphical user interface (502) may also be provided to allow a user to adjust the simulation settings (504) and establish new connections with input/output components to be utilized in simulation.

## Description

The present invention relates generally to a system and method of simulating control systems, and more particularly, to a system and method of simulating dynamic feedback control systems.

Turbine simulation can be defined into multiple platforms including Hardware in the Loop simulation and Table-Top simulation (also referred to as non-HITL simulation). Simulations of dynamic feedback control systems may be classified as being hardware-in-the-loop (HITL) simulations or non-HITL simulations. HITL simulations systems include some hardware elements from the actual (or target) control system being simulated in direct or indirect communication with other elements of the HITL simulation system. Non-HITL simulations do not include any hardware elements from the actual (or target) control system in the simulation system.

Hardware in the loop simulation tests all aspects of the controls system as well as the input and output cards that are attached to that controller. Hardware in the loop simulation is primarily used for factory acceptance tests (FAT) by control system engineers to prove functionality of the control system to the customer. In the operation of the HITL simulation system, the control system receives measured input signals from a simulated equipment model, performs certain internal calculations, and then outputs command signals to the simulated equipment model. Given that in a typical HITL simulation special purpose and proprietary components of the actual control system hardware and software are utilized, these actions are typically repeated at high speed on a precisely controlled interval. However, as these elements are designed to operate according to a strict set of criteria, the resulting dynamic feedback simulation of an HITL simulation is subject to a number of operational limitations such as strict real-time operation, non-stop operation and execution always initiates in a single preprogrammed state. Typically, hardware in the loop is the most time efficient, though costly, approach to simulating turbine control.

In a typical non-HITL simulation, a simulated model of the actual control system software, usually via a translation into the same simulation software environment as the equipment model. This integrated simulation of the process equipment and the control system contains a number of inherent problems such as a potential for errors in the simulated control system model due to the translation process, loss of fidelity and realism due to the simulation of the control logic, additional steps are required to translate and embed the control system logic into the simulation software, and modifications made to the simulated control system logic during the simulation process must be extracted from the simulation and applied to the actual control system software. The fidelity in the system refers to the ability of the simulation and controls to match the operation of the running power plant.

Non-HITL simulation, typically, is used by the control system engineers to verify that the control system is completing the operation in the correct sequence that is intended. The non-HITL simulation does not include any I/O validation. However, the non-HITL simulation require the use of trainers which add to the development cost of the simulation and inhibits high speed validation.

To compound the inherit drawbacks associated with both HITL simulation and non-HITL simulation, the modernization of power plant control systems has also created challenges for simulating real-life controller upgrades or simulating maintenance or troubleshooting actions before such actions are actually implemented into the actual control system. Analog power plant control systems simulation were relatively easy compared to more modem digital control systems (DCS). It is also more difficult and costly to provide accurate simulations of DCS controllers for providing training scenarios for control system operators. As the DCS systems become more complex, they are also becoming increasing difficult and increasingly expensive to fully emulate.

According to an embodiment of the invention, there is disclosed a method for simulating dynamic feedback control systems that include establishing a connection via a common access to a shared memory between the control system logic of a controller to be emulated and a simulation model. State data from a previous simulation associated with the control system logic and the simulation model is retrieved from memory to initialize another simulation run. The state data associated with the simulation model and the control system logic are then synchronized with a timing and control mechanism and a simulation of the controller is executed.

In accordance with one aspect of the invention, the method further includes, upon executing the simulation of the controller, updating at least a portion of the state data associated with the simulation model and the control system logic and storing the updated state data in a database. According to another aspect of the invention, the method further includes, prior to executing a simulation of the controller, accepting commands from a graphical user interface for adjusting at least a portion of the state data associated with the simulation of the controller. In accordance with yet another aspect of the invention, the method further includes, prior to executing a simulation of the controller, accepting commands from a graphical user interface for adjusting at least a portion of the state data associated with the simulation of the controller.

According to yet another aspect of the invention, the method further includes, prior to executing a simulation of the controller, accepting commands from a graphical user interface for adjusting at least one control system setting associated with the simulation of the controller. In accordance with another aspect of the invention, the method further includes accepting commands from a graphical user interface for performing a regression analysis on at least a portion of the state data to predict future simulation results. According to another aspect of the invention, the method further includes accepting commands from a graphical user interface for plotting simulation data associated with the simulation model. In accordance with yet another aspect of the invention, the execution of the simulation of the controller includes stepping from a specified starting step to a specified end step and then stopping and waiting for the next command or calling program.

According to another embodiment of the invention, there is disclosed a method of preparing a simulating dynamic feedback control systems that includes establishing a connection via a common access to a shared memory between at least a portion of control system logic of the controller and a simulation software, where the simulation software includes a simulation model. The method also accepts commands received from a graphical user interface to establish a connection of the input/output (I/O) components between the at least a portion of control system logic and the simulation software. The method further includes detecting an error in the (I/O) component connection; identifying input and output signal naming mismatches associated with the error; and correcting input and output signal naming mismatches.

In accordance with one aspect of the invention, the method further includes retrieving state data associated with the at least a portion of control system logic and the simulation model, where the state data is associated with a previous simulation; synchronizing the simulation model and the control system logic; and executing a simulation. According to another aspect of the invention, the method further includes, upon executing the simulation, updating at least a portion of the state data associated with the simulation model and the control system logic; and storing the updated state data in a database. In accordance with another aspect of the invention, the method further includes accepting commands from a graphical user interface for adjusting the state data associated with the simulation.

According to yet another aspect of the invention, the method further includes, prior to executing a simulation, accepting commands from a graphical user interface for adjusting at least one control system setting associated with the simulation. In accordance with another aspect of the invention, the method further includes accepting commands from a graphical user interface for performing a regression analysis on at least a portion of the state data to predict future simulation results. According to yet another aspect of the invention, the method further includes, accepting commands from a graphical user interface for plotting simulation data associated with the simulation model. In accordance with one aspect of the invention, the execution of the simulation includes stepping from a specified starting step to a specified end step and then stopping and waiting for the next command or calling program.

According to yet another embodiment of the invention, there is disclosed a system for simulating dynamic feedback control systems that includes simulation software in communication with shared memory, where the simulation software includes a simulation model. The system also includes at least a portion of control system logic associated with a controller in communication with the shared memory, where the shared memory establishes a connection via a common access to at least a portion of control system logic of the controller and the simulation software. The system further includes a database in communication with the simulation software and controller, where state data associated with the control system logic and the simulation model is stored in the database. The system also includes a timing and control mechanism in communication with the controller and the simulation software, where the timing and control mechanism synchronizes the simulation software and the at least a portion of the control system logic.

In accordance with one aspect of the invention, the control system logic of the controller is hosted on the same operating system as the simulation model. According to another aspect of the invention, the system further includes a graphical user interface in communication with the at least a portion of the control system logic for accepting user commands configuring or executing the simulation. In accordance with yet another aspect of the invention, the graphical user interface includes a watch window menu, where the watch window plots live data associated with one or more simulation variables. According to yet another aspect of the invention, the graphical user interface includes an interactive simulation menu, where the interactive simulation menu provides the option of increasing or decreasing a step size associated with the state data of the simulation.

Having thus described various aspects and embodiments of the invention in general terms, reference will now be made to the accompanying drawings, which are not necessarily drawn to scale, and wherein:
FIG. 1 shows a system for the simulation of complex, dynamic feedback control systems in accordance with an exemplary embodiment of the invention.
FIG. 2 is a flowchart directed to setting up and executing a simulation in accordance with an exemplary embodiment of the invention.
FIG. 3 is an overview of the simulation software showing the multiple components that work in conjunction with a control system emulator in accordance with an exemplary embodiment of the invention.
FIG. 4 shows an exemplary control system emulator in accordance with an exemplary embodiment of the invention.
FIG. 5 shows a simulation executive user interface in accordance with an exemplary embodiment of the invention.

Various aspects of the present invention are directed to a cost effective software based simulation that enables advanced levels of functionality and validation of controls and operability in less time than current HITL and non-HITL simulation systems. Various aspects of the present invention are directed to a simulation system that achieves the advantages of both hardware-in-the-loop (HITL) and non-HITL environments and minimizes the disadvantages of each. Various aspects of the present invention involve a process referred to as "virtual stimulation," which takes the underlying source code of a DCS and ports it to run on a low-cost computer platform. The systems and methods of various aspects of the present invention provide a framework for simulation that combines the extensive debugging capabilities and operational flexibility of a non-HITL simulation environment with the realism and authenticity of a real-time HITL simulation environment.

Various aspects of the present invention provide an environment wherein the actual control system application software for a particular system may be tested against a simulation model of the equipment with full debug capabilities and flexibility in control of simulation execution. The control system may operate in real time and may operate independent of the emulator. For example, the emulator may be told to step every one millisecond, but the emulator may assume that is a controller scan rate of 40 milliseconds. Moreover, various aspects of the present invention provide a new capability for analysis and design of dynamic feedback control systems based on simulation. This capability will provide improvements in productivity during design and development activities and is enabling technology for end-user training.

Additionally, various aspects of the present invention improve the accuracy and quality of control system design, reduces defects and allows more thorough study of the operability of the process being controlled. The same features that will make the simulation platform of various aspects of the present invention more effective for design teams will also provide the basis for operator training simulators, allowing customers to train their operations personnel and achieve more effective operations of various equipment. Various aspects of the present invention may also be suitable for applications involving the simulation of gas turbine, steam turbine, or combined-cycle power plants. Further, various aspects of the present invention may be used in multiple facets including control system logic development and validation, machine design validation, operability studies, customer training, regression analysis, and external sales/revenue.

The present invention is described below with reference to block diagrams of systems, methods, apparatuses and computer program products according to an embodiment of the invention. It will be understood that each block of the block diagrams, and combinations of blocks in the block diagrams, respectively, can be implemented by computer program instructions. These computer program instructions may be loaded onto a general purpose computer, special purpose computer, or other programmable data processing apparatus to produce a machine, such that the instructions which execute on the computer or other programmable data processing apparatus create means for implementing the functionality of each block of the block diagrams, or combinations of blocks in the block diagrams discussed in detail in the descriptions below.

These computer program instructions may also be stored in a computer-readable memory that can direct a computer or other programmable data processing apparatus to function in a particular manner, such that the instructions stored in the computer-readable memory produce an article of manufacture including instruction means that implement the function specified in the block or blocks. The computer program instructions may also be loaded onto a computer or other programmable data processing apparatus to cause a series of operational steps to be performed on the computer or other programmable apparatus to produce a computer implemented process such that the instructions that execute on the computer or other programmable apparatus provide steps for implementing the functions specified in the block or blocks.

Accordingly, blocks of the block diagrams support combinations of means for performing the specified functions, combinations of steps for performing the specified functions and program instruction means for performing the specified functions. It will also be understood that each block of the block diagrams, and combinations of blocks in the block diagrams, can be implemented by special purpose hardware-based computer systems that perform the specified functions or steps, or combinations of special purpose hardware and computer instructions.

Various aspects of the invention may be implemented through an application program running on an operating system of a computer. Various aspects of the invention also may be practiced with other computer system configurations, including hand-held devices, multiprocessor systems, microprocessor based or programmable consumer electronics, mini-computers, mainframe computers, etc.

Application programs that are components of the invention may include routines, programs, components, data structures, etc. that implement certain abstract data types, perform certain tasks, actions, or tasks. In a distributed computing environment, the application program (in whole or in part) may be located in local memory, or in other storage. In addition, or in the alternative, the application program (in whole or in part) may be located in remote memory or in storage to allow for the practice where tasks are performed by remote processing devices linked through a communications network. Exemplary embodiments of the present invention are more fully described hereinafter with reference to the accompanying drawings, in which like numerals indicate like elements throughout the several drawings. Indeed, the present invention may be embodied in many different forms and should not be construed as limited to the embodiments set forth herein; rather, these embodiments are provided so that this disclosure will satisfy applicable legal requirements.

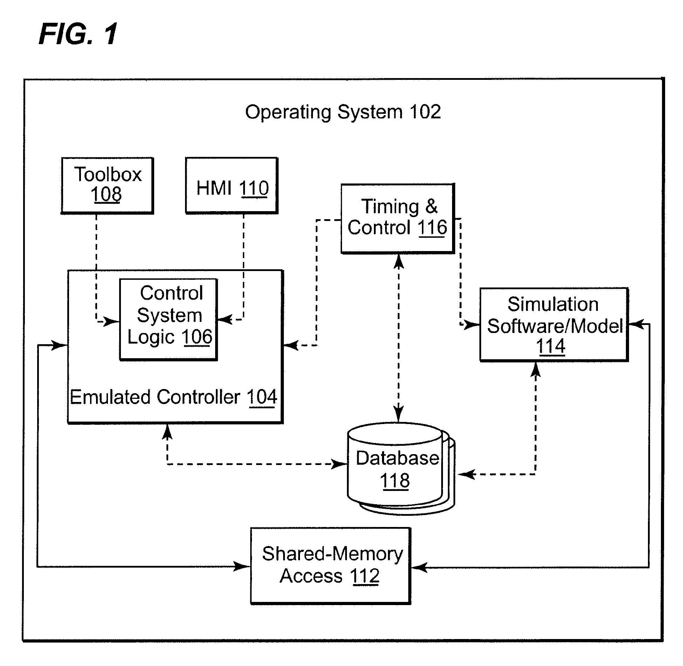

FIG. 1 shows a system for the simulation of complex, dynamic feedback control systems in accordance with an exemplary embodiment of the invention. In exemplary embodiments of the present invention, the internal architecture of the real-time control system software to be simulated is known and the source code is available for modification. In an exemplary embodiment of the invention, the control system may be hosted on an QNX real-time operating system. As a microkernel-based operating system, QNX runs most of the operating system in the form of a number of small tasks. In the case of QNX, the use of a microkernel allows developers to turn off any functionality they do not require without having to change the OS itself. The control system software is a layered product, wherein the application software rests upon a layer of utility processes known as the runtime, which in turn rests upon the QNX operating system. Consequently, the runtime layer serves to isolate the application software from the details of the QNX operating system.

As shown in the exemplary embodiment of FIG. 1, the invention includes a port of the runtime environment to the operating system 102, such as the Microsoft Windows^{®} operating system. In an exemplary embodiment, porting runtime is taking the QNX specific functionalities along with the control system blockware and creating a Microsoft Windows^{®} software wrapper allowing the same functionalities to be executed in a Microsoft Windows^{®} environment. Utilizing the port of the runtime to the operating system 102 environment, the actual control system logic 106 of an emulated controller 104 may be hosted on the same PC as the simulation model for the equipment being simulated. In exemplary embodiments of the present invention, the runtime and related applications tools are programmed in C and C++, using the Microsoft Visual Studio design suite. These tools and software languages are compatible with the simulation software package, executing on the Windows^{®} operating system.

In exemplary embodiments of the present invention, the implementation of the real-time control system logic 106 is layered, with minimal dependence on the host computer's real-time operating system. The control system application software language, it's supporting development tools and programming environment are compatible with those of the equipment simulation software/model 114. The simulation software/model 114 used to implement the equipment model may also have the ability to support communication with other third party software packages. The simulation software has a flexible means of incorporating third party code into the resulting simulation, including in this case a flexible mechanism for access to shared memory as the means of communication with third party software programs. An application programming interface (API) is used to accomplish this functionality.

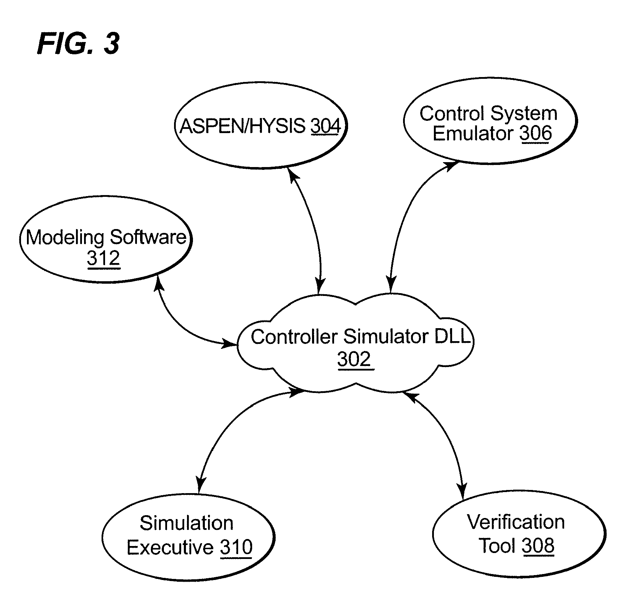

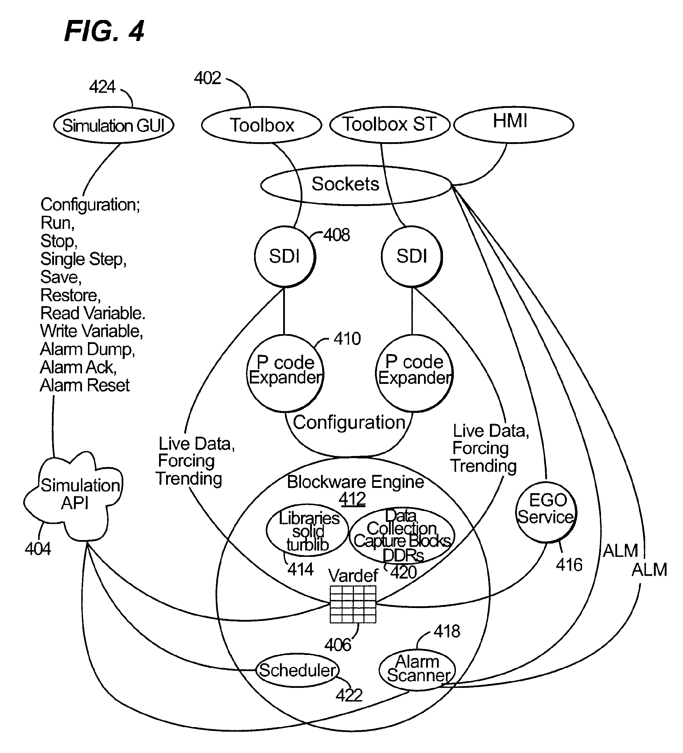

A communication channel is established via a common access 112 to a region of shared memory between the two primary components of the simulation system: the control system logic 106 and the simulation software/model 114. In the exemplary embodiment of FIG. 1, both the simulation software/model 114 and the Windows^{®} port of the runtime associated with the control system logic 106 utilize shared-memory access mechanisms 112, to serve as a communications channel between the simulation equipment model and the control system application software logic 106 of the emulated controller 104. A timing and control mechanism 116 coordinates and synchronizes execution of the simulation equipment model and the control system logic 106. A database mechanism 118 saves and restores the state of the executing simulation, including both the simulated equipment model and control system logic 106, at any point in time. The simulation software/model 114 and control system logic 106 of the emulated controller 104 are discussed in more detail below with reference to FIGS. 3 and 4.

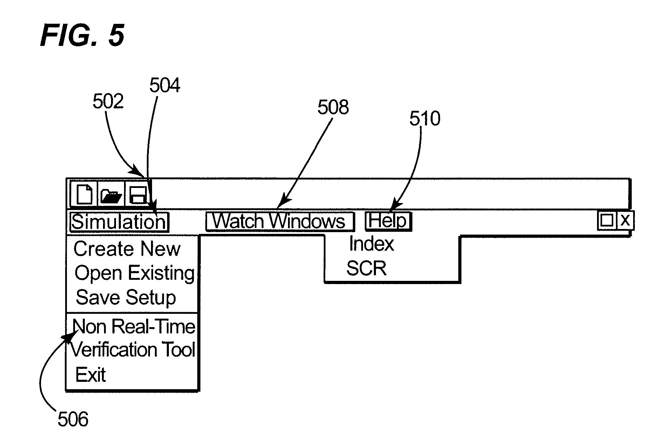

A simulation executive graphical user interface is provided to control and coordinate all aspects of the execution of the simulation system components, including both simulation software/model 114 and control system application software. Execution control and synchronization of the control system logic 106 and the simulation model is affected by the simulation executive graphical user interface. The simulation executive graphical user interface allows for the availability of the standard control system software tools, including the toolbox 108, trend recorder, and HMI (Human Machine Interface) 110 among others, with features identical to those available in the standard real-time control system platform. Access to the control system logic 106 is obtained through the toolbox 108 and HMI 110 such as a GE Fanuc Automation North America, Inc.'s Cimplicity^{®} Workbench Human Machine Interface (Cimplicity^{®} HMI). An exemplary embodiment of a graphical user interface is discussed in more detail with reference to FIG. 5.

From the emulated controller 104 perspective, simulation may be separated into three groups broadly defined by their user community: Operator Simulation, Requisition Simulation, and Interactive Simulation. Operator Simulation usually targets customer training and is the most sensitive to hardware cost. A software-only solution running in an operating system such as Microsoft Windows^{®} is an exemplary solution. Requisition simulation supports application code validation and requires the ability to interact with external devices, and support for a mix of simulated and real I/O. Any time the controller accesses I/O it must be hosted in the actual hardware. Interactive simulation is used in the internal development and analysis of models and control algorithms. Interactive simulation usually requires control of application code scheduling, and advanced debugging features.

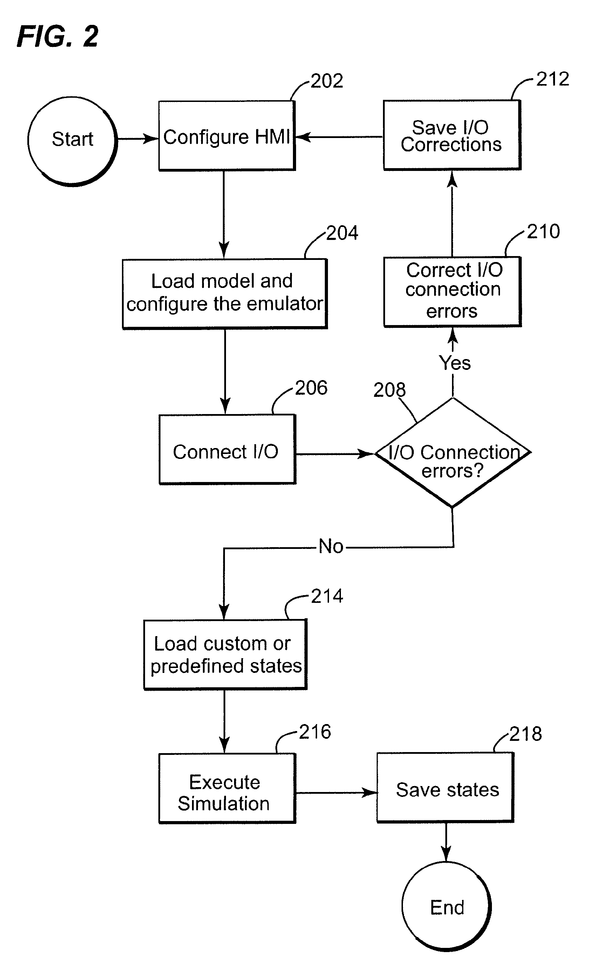

FIG. 2 is a flowchart directed to setting up and executing a simulation in accordance with an exemplary embodiment of the invention. The process begins in step 202 with the configuration of the HMI (Human Machine Interface). The HMI and toolbox may be opened if necessary to view the control system software and alter settings. Next, step 204 is invoked to execute the simulator system by loading the simulation model, configuring the emulator for the controller and establishing control system logic access to the shared memory. Step 206 is then invoked to establish a connection of the I/O (input/output) components between the control system logic software and the simulation model.

In the exemplary embodiment of the invention shown in FIG. 2, step 208 is invoked to determine if there are any I/O connection errors. If there are any errors detected in the attempt to establish a connection, a notice will be given to the operator through the simulation executive graphical user interface. Further, if there are errors with the I/O connections, then step 210 corrects the error. An example of error correction would include, correcting the appropriate reference names in either the simulation model or the simulator control software corresponding to the I/O connection resulting in an error. Next, step 212 stores the corrected information (e.g., I/O reference names) for future use and reduction in setup time. If no errors are detected and the I/O connections are successful then step 214 is invoked to load the initial conditions or state data (or state files) for the emulated controller and the simulation model from a data repository. Next, the simulation is executed in step 216 and the state data is then saved for future use in step 218. A unique aspect of this particular setup is the capability of the simulation to store data for future use and learn and predict results based on that stored data possibly through various regression analysis methods appreciable by one of ordinary skill in the art. The regression analysis conducted via the graphical user interface, discussed below, utilizes the stored state data for previous simulations to determine adjustments to aspects of the simulation model and/or the emulation settings to create more accurate simulations.

FIG. 3 is an overview of the simulation software showing the multiple components that work in conjunction with a control system emulator in accordance with an exemplary embodiment of the invention. As shown in FIG. 3, the simulator system of the present invention consists of multiple components that work in conjunction with the control system emulator(s) 306. The main components of the simulator system are the Controller Simulator DLL (dynamic link library) 302, Simulation Executive 310, Verification Tool 308, Modeling Software 312 and external turbine modeling software or third party packages, such as AspenTech's Aspen HYSYS^{®} 304, as shown in FIG.3.

The controller simulator DLL 302 is a dynamic link library that serves as the means for setup and communication of all external programs of the simulation environment. The controller simulator DLL 302 enables the availability of all application programming interfaces (APIs) to the processes associated with the controller simulator DLL 302 and enables external interfaces to communicate to multiple processes from a single point of entry. An API is a program based call that can be used by other programs to gain access to specific functionality of a program without accessing its source code. Therefore, the API provides a control and monitoring interface to other software applications.

The controller simulator DLL 302 may set up all the input/output (I/O) connections in a contract form by specifying a specific identification number that is known between the modeling software 310 and the emulator 306. The control system consists of variables that are either analog or digital (also referred to as real or Boolean). A contract form is a specific block of shared memory that correlates to specific signals/variables, such as Boolean and/or analog/real type variables. In an exemplary embodiment of the invention, these contracts are to be made known to the emulator 306 through an API called "Register Contract ID." The Register Contract ID API will create a block of shared memory that will be used as a communication means between the attached processes.

In an exemplary embodiment of the invention the controller simulator DLL 302 exposes a run command API to all external programs to enable a single point of entry into the emulator 306 and cause the modeling interface to enable a synchronized run. The controller simulator DLL 302 may also expose a global stop command API to the calling program. When executed the stop command closes all dependent process and destroys all windows attached to that process. Further, the controller simulator DLL 302 may expose a step command that will step all attached processes by the number of steps provided by the calling program. Attached processes are all operating system (e.g., Microsoft Windows^{®}) processes that were started when the simulation was executed, such as the simulation model, emulator, etc. When executing the step command the simulation "steps" from a specified starting step to the specified end step and then stops and waits for the next command or calling program.

The controller simulator DLL 302 also may expose a save command that will trigger a global save of all variables for each process that is attached to the controller simulator except the calling program. Also, the save command may accept a flag from the calling process that will identify the format that the controller simulator DLL 302 should save the data (by variable, data dump, etc.). Moreover, the controller simulator DLL 302 may expose a restore command that will trigger a global restore of all variables for each process that is attached to the controller simulator 302 except the calling program. Further, the restore command may accept a flag from the calling process that will identify whether or not the restore should be done by variable or by data dump. Data dumping is a binary restoring of all variables. This restore makes the assumption that the running software has not changes in anyway. The restoring by variable process writes the known values one at a time to each individual signal name within the software system.

The controller simulator DLL 302 may also expose a pause command that triggers a global pause of all attached processes to the controller simulator DLL 302. During the paused state, the attached processes wait for a resume command or a step command from the controller simulator DLL 302. The controller simulator DLL 302 may also expose a named variable signal list of all attached processes except the calling process. Moreover, the device to which the list is attached is identified (i.e., Turbine Controls System Gas Turbine Model, G1, S1 etc.). This exposure does not interfere with the normal operations of the simulation environment. The controller simulator DLL 302 should expose an I/O-report API that will list all input/output names that are in the attached processes. This allows the calling process the ability to identify any mismatches between the communicating processes.

The controller simulator DLL 302 may also expose an API that will give the calling program the ability to toggle a simulation flag on a specified variable and write a user defined value to that variable. This would be used for fault injection. For example, the user could write a faulted speed signal to the control system to see how the control system responds. This simulation command is a direct communication to the control system emulator 306. The controller simulator DLL 302 may also expose APIs to the calling program that will enable the end user the ability to read and write a single analog or digital variable as well as force logics that are attached to the control system emulator 306. These read, write and force logic commands are also direct communications to the control system emulator 306.

The verification tool 308 is a GUI (graphical user interface) that consists of components to emulate, plot, automate and perform regression analysis on a simulation system. The verification tool 308 may also contain the basic functionality of the simulation executive 310. The verification tool 308 may include HMI emulation, plotting, automation and regression. The HMI emulation enables the end user the ability to run the basic functionality of the power plant simulation without having HMI software, such as Cimplicity^{®} HMI software, installed on his or her PC. Plotting allows the end user to plot data from the simulation model 310 and the control system on the same plot. It also gives the end user an analytical tool to use in validation/verification of the control system logic. Automation consists of a standard list/combo box that gives the user the capabilities to insert specific actions that they wish to complete. Also, automation provides the user the capabilities to write a script in a standard text format for import into the verification tool 308. In addition to this import functionality, the novice user can choose to write and save his scripts form the graphical user interface. The program parses this data and enter it into memory in the correct format for automation. The verification tool enables the use of standard trending formats/tools utilized by the turbine control system. The verification GUI is also pre-enabled with all of the controller simulator DLL APIs.

In an exemplary embodiment of the invention, there is a direct interface between the verification tool 308 and a data analysis tool currently in operation for power plant data analysis. This interface will be an API call that will pass plot data and signature data to the host program and the host program will analyze the plot against it's corresponding signature and send back results based on a deviation from a mean. The bounds will be set by the user before the program starts. Signature data is data that has been collected from previous simulation or power plant operation and has been proven to be valid and the correct operation of the power plant.

Modeling software 312 is an additional component and expense to the simulation system. By using a pre-build process the models may be compiled as a stand-alone model and reduce or eliminate certain expenses associated with the modeling process.

In an exemplary embodiment of the invention, MSC Software Easy5 modeling software may be used as the building block for the power plant simulation development and compile the source code as a stand-alone for customer simulation. This will be a separate tool form the simulator system. Aspen HYSYS^{®} 304 is an interactive process modeling solution that enables engineers to create steady state models for plant design, performance monitoring, troubleshooting, operation improvement, etc. Aspen HYSYS^{®} are both external software that will have two way communication to the simulation software through the controller simulator DLL.

In exemplary embodiments of the invention, the simulator system may also contain an I/O configuration tool that will assist the end user with input and output signal names to and from the model and controller being emulated. This tool may identify the names that are mismatched and give the user the capability to enter a new name. After the user has resolved all naming or data type mismatches, they will have the option to save the configuration for future use. This data may be back fed into the simulation executive 310 and used in future setups before asking the user for input. This tool may also be made backward compatible to a tabletop (non-HITL) simulation.

The simulator system may also analyze the system during the startup/setup process to determine the maximum speed that can be achieved during any run cycle. This number may then be placed into the simulation executive 310 as the upper specification limit (USL) for the time step that can be achieved during the power plant simulation. The user may also be given the capability to increase and decrease the time step to the USL.

FIG. 4 shows an exemplary control system emulator in accordance with an exemplary embodiment of the invention. As is shown in FIG. 4, the exemplary embodiment is a combination of multiple software units that communicate together to enable commonality across platforms. In an exemplary embodiment of the invention, the emulator is a set of software executables that emulates some of the basic functionality of one or more controllers. The emulator is configured just like a real controller using the toolbox 402. An application programming interface (API) provides direct access to the variable space (vardef) 406 so that input and output signals may be driven by an external software model. The API 404 provides a control and monitoring interface to other Windows® software applications.

The toolbox configuration and monitoring interface is built on a TCP/IP socket library. This provides a normalization layer that allows the toolbox 402 to be used with no changes, even if it is executing on the same PC as the simulator/emulator. The emulator relies on the generation of a symbol table by the toolbox 402 to perform state variable restoration and variable access by name. In an exemplary embodiment of the invention, the symbol table contains the following fields for all signals (or variables) used in the controller: Full signal name, Address token, Initial / Current Value. Sockets are standard features available within the Microsoft Windows® environment for communication through TCP/IP protocol. Toolbox ST, shown in FIG. 4, is a GE proprietary control system software GUI that is used to configure/modify turbine control logic. In alternative embodiments of the invention, other GUIs may be used.

SDI 408 protocols and configuration files also is supported. SDI is a GE proprietary protocol used for communication between the controller and the toolbox, though other communications protocols may be implemented. A separate Pcode expander 410 is created for each mode. The Pcode expander 410 is a software interpreter that reads binary language and interprets how the control system should operate. Each Pcode expander 410 produces a common set of configuration information to drive the blockware engine 412. A blockware engine 412 is the emulated controller logic over which executes the control system sequencing. Any configuration information from the toolbox 402 that is not needed or is not supported may be ignored by the Pcode expander 410 and acknowledged as successful to the toolbox 402 as required. A single set of blockware libraries 414 may supports multiple emulator modes since there are only minor datatype changes between them. Blockware libraries 414 are standard sets of functions that are used when building control system logic (e.g., Rung Ladder Diagram PLC Logic).

The application variable space (vardef) 406 may be implemented as a global memory region. Variable space is a block of memory where the emulator stores the variable values. Fast access is required through the API 404 for save, restore, and backtrack operations. The target is less than 100 mS save time. The emulator may maintains application code that does not exist in the vardef 406.

Online loads to the emulator from the toolbox 402 should preserve the state of the vardef 406 except to initialize new or all variables as directed by the command. In exemplary embodiments of the invention, there are no performance requirement, synchronization requirement, or external data production requirement for online loads. All of these features supported by the real controller may be compromised in the simulator as long as the vardef 406 preservation is accurate with respect to the real controller. The term compromise refers to the initialization of modified control logic and its effect on the operation of the turbine controls. If the new logic added will create an adverse effect on the turbine then an online download will be disabled. When relating to the real controller the term compromise means that the emulated controls will have the same functionality as the real controller.

The emulator maintains variables of interest that are accessible via the toolbox 402. In an exemplary embodiment of the invention the variables of interest contain read-only status information. A variable of interest may be any variable that the user chooses to monitor during the execution of the simulation. In some exemplary embodiments of the invention the variables of interest may be accessed through special tokens, while in other exemplary embodiments the variables of interest are accessed through an intrinsic variable method. This refers to access by token address (memory address space) or by variable name. Though the variables of interest may be made accessible to the operator, the emulator may maintain some of these variables so that the toolbox 402 does not display confusing or erroneous information about the controller. Many of the variable values may be set to a default state at start-up and then left alone. At least two read variable commands may be supported. One read variable command may provide access by symbol name and the second read variable command may provide access by token. The read variable commands may support multiple variables per access. At least two write variable commands may also be supported. One write variable command may provide access by symbol name and the second write variable command may provide access by token. The commands may support multiple variables per access.

A networking communication protocol for use with Power Plant Control systems such as GE's Ethernet Global Data (EGD) protocol may be decoupled from the application code or driven by the output thread of an application after each frame. EGD is a TCP/IP protocol that is used for communication to the HMI. An EGD exchange map is created that is transmitted periodically by EGD service 416 regardless of whether it is updated by application code.

Further, in the exemplary embodiment shown in FIG. 4, the emulator supports a simple alarm queue implemented by a simplified alarm scanner 418. Exemplary embodiments of the invention implement the alarm queue with the use of API, while other embodiments may support controller-specific alarm protocols. In an exemplary embodiment of the invention, an interface may be provided for simple process alarm functions. The dump request returns the process alarms on the queue. A dump request is an asynchronous protocol that runs within the HMI process that waits for commands from external processes. The dump request is one command that tells the alarm manager to have all of its existing alarms cue the calling program. Acknowledge and reset commands may be supported for individual alarms and all alarms in the queue. In another embodiment of the invention, an interface may be provided for simple hold alarm functions. The dump request returns the hold alarms on the queue. Again, acknowledge and reset commands may be supported for individual alarms and all alarms in the queue.

The emulator may also support data collection 420 such as capture blocks and dynamic data recorders, etc. The memory required for capture blocks may be allocated from heap memory or another memory location. In exemplary embodiments of the invention, the data from capture blocks is only accessible through the traditional SDI interfaces 408 and not through the API 404. In alternative embodiments of the invention, a trainer may be developed and deployed for requisition simulation as required. A trainer may be a PC or other common hardware platform used to host the same software running in the real controller, but with deprecated features such as a lack of support for native I/O, or redundancy features.

Various commands are used to configure the simulator. Such commands may involve selecting the model type of the controller being simulated (e.g., the GE Mark VI Digital Control System (DCS) or the GE Mark Vie DCS, etc.), selecting the run mode (e.g., Real-time - scheduling clock runs at frame rate, or Fastest-possible - the blockware 412 executes nose to tail in a tight loop), or configuring the directories (e.g., the location of symbol table files, error logs, etc.). The symbol table should be loaded on start-up if available. All API commands that require a symbol table should error out if the table is not loaded. On a run command, the scheduling clock source 422 is connected to the blockware engine 412, picking up simulation time where it last left off. On a stop command, the scheduling clock source 422 is disconnected from the blockware engine 412, effectively halting simulation time. In single step mode, one frame of application code is executed and then halted.

In the exemplary embodiment shown in FIG, 4, the emulator is able to save and restore variables by name rather than by address (i.e. token) to allow for the saving and restoring of the controller state information across major application code changes. In an exemplary embodiment of the invention, the emulator will save the state of the controller by capturing the entire vardef 406 in raw form and then associate the capture with a particular symbol table file allowing for fast save times.

A backtrack operation is an initialization of state conditions within a controller where there have been no major application code changes (i.e. the vardef 406 has not changed). The backtrack operation may be accomplished by overwriting the vardef 406 with the raw saved values. The restoration operation indicates that a major application code change may have occurred prior to restoration. It is not sufficient to bulk copy the vardef 406 since its layout may have changed. To insure the best chance of restoring the vardef 406 to a desired state, the emulator (1) zeros the vardef 406; (2) loads the existing symbol table and the requested restore symbol table; and (3) for every signal in both symbol tables, initialize the variable using the value and the token found in the requested restore symbol table.

The simulation GUI 424 may be a reference design for third party developers of simulation executives. The simulation GUI 424 may also include a working example of every API call supported by the emulator. A more detailed discussion of the simulation GUI is provided below with reference to FIG. 5.

FIG. 5 shows a simulation executive user interface 502 in accordance with an exemplary embodiment of the invention. The simulation executive user interface 502 is a graphical user interface (GUI) that controls all of the APIs to the simulation system. The simulation executive user interface 502 may include various menu items for ease of use. These menu items may be separated into various toolbar/setup menus that may be expanded and include nested submenus such as simulation menu 504, non-real-time submenu 506, watch windows 508, etc. Additional submenus appreciable by one of ordinary skill in the art, such as a help submenu 510 shown in FIG. 5, may also be included.

In the exemplary embodiment of FIG. 5, the various toolbar menu may provide access to basic items that exist on a typical windows GUI including but not limited to a "New" menu item - for creating a new simulation, a "Save" menu item - for saving the current simulation in its present state, an "Open" menu item - for loading an existing simulation, etc. The toolbar menus may also include commands that are not shown in the exemplary simulation executive user interface 502 in FIG. 5 such as run, stop, pause, resume, save and restore. The toolbar menus may also be customized to provide access to various setting options and commands for the user to configure a simulation run or analyze an existing (or previously stored) simulation. Examples of possible settings that may be adjusted are time step, execution control through the step command, as well as pausing and resuming all processes.

In the exemplary embodiment of FIG. 5, the simulation submenu 504 includes the menu items (or buttons) Create New, Open Existing, etc. The Create New item opens a GUI to create a new simulation configuration that will consist of the device name(s) that are going to be configured in the simulation, the network addresses assigned to each device along with the HMI, Unit Data Highway (UDH), and Plant Data Highway (PDH) network addresses. UDH is the data distribution TCP/IP protocol that is used in a power plant to transport data between all power plant devices. PDH is the distribution TCP/IP protocol that connects the customer network to their power plant hardware. In an alternative embodiment, the Create New or Open Existing GUI items may also contain an auto configure network address checkbox to allow the user to assign all of the above mentioned addresses to a specific NIC (Network Interface Card) card. The simulation submenu 504 may also have status indicators for each device connected to the simulation system that will be monitored on a regular basis. In an exemplary embodiment of the invention, the status indicators will show a red status when a device is not started and a green status when the device is running.

Additional command buttons, not shown in FIG. 5, may be added to the simulation submenu 504 to provide addition functionality such as "Start Simulation," which starts all processes attached to the simulation system; "Close Simulation," which destroys all windows and processes attached to the simulation system; "Reboot Controllers," which cycles the processes of the emulator; "Cancel," which closes the GUI and brings the user back to the main screen; "Save," saves the configuration entered by the user; "Restore," restores the configuration from a previously existing setup file. Other commands appreciable by those of ordinary skill in the art may also be implemented.

The Interactive Simulation submenu allows for access to an additional submenu that includes menu items for save, pause, restore and step functionalities. In exemplary embodiments of the invention, the non-real-time submenu 506 may enable the user to increase and decrease step size of a simulation through the use of a slide bar or other interface (e.g., buttons, textbox, etc.). In addition to the above, the non-real-time submenu 506 may include functionality such as a list box that will store the name and text of all saved states along with the path/location and any comments added by the user regarding the simulation. The exemplary simulation executive of FIG. 5 also has a direct link to the verification tool, which may, in certain embodiments, be a standalone program.

As shown in FIG. 5, a "watch windows" submenu 508 may also be included and may have a browse button that will prompt the user whether they want to view the model or control system variables. The model and control system variables may be separated by a combo/list box functionality allowing the user the capabilities to easily view the variables from their source. A combo/list box is a divided GUI interface that will enable the end user to view all variables from the attached processes in separate columns on the user screen. In addition to this functionality, the watch windows submenu 508 may provide the ability to change the value of any analog (real) value that is not being written to and force any logic within the controller. Further, the watch windows submenu 508 may also provide the ability to select all the signals in the watch list and have an option to plot the live data.

Many modifications and other embodiments of the inventions set forth herein will come to mind to one skilled in the art to which these inventions pertain having the benefit of the teachings presented in the foregoing descriptions and the associated drawings. Therefore, it is to be understood that the inventions are not to be limited to the specific embodiments disclosed and that modifications and other embodiments are intended to be included within the scope of the appended claims. Although specific terms are employed herein, they are used in a generic and descriptive sense only and not for purposes of limitation.

## Claims

1. A method of simulating dynamic feedback control systems comprising:
establishing a connection via a common access to a shared memory (112) between at least a portion of control system logic (106) of a controller and a simulation model (114);
retrieving a plurality of state data associated with the control system logic and the simulation model, wherein the state data is associated with a previous simulation;
synchronizing the plurality of state data associated with the control system logic and the simulation model with a timing and control mechanism (116); and
executing a simulation of the controller.

2. The method of Claim 1, further comprising:
upon executing the simulation of the controller, updating at least a portion of the state data associated with the simulation model and the control system logic; and storing the updated state data in a database (118).

3. The method of any preceding Claim, further comprising:
accepting commands from a graphical user interface (502) for performing a regression analysis on at least a portion of the state data to predict future simulation results.

4. The method of any preceding Claim, wherein the execution of the simulation of the controller including stepping from a specified starting step to a specified end step and then stopping and waiting for the next command or calling program.

5. A method of preparing a simulation dynamic feedback control systems comprising:
establishing a connection via a common access to a shared memory (112) between at least a portion of control system logic (106) of the controller and a simulation software, wherein the simulation software includes a simulation model (114) ;
accepting commands received from a graphical user interface (502) to establish a connection of the input/output (I/O) components between the at least a portion of control system logic and the simulation software;
detecting an error in the (I/O) component connection;
identifying input and output signal naming mismatches associated with the error; and
correcting the input and output signal naming mismatches.

6. The method of Claim 5, further comprising:
retrieving a plurality of state data associated with the at least a portion of control system logic (106) and the simulation model, wherein the state data is associated with a previous simulation;
synchronizing the simulation model (114) and the control system logic; and
executing a simulation.

7. The method of Claim 5 or Claim 6, further comprising:
accepting commands from a graphical user interface (424) for adjusting the state data associated with the simulation.

8. The method of any one of Claims 5 to 7, further comprising:
prior to executing a simulation, accepting commands from a graphical user interface (424,502) for adjusting at least one control system setting associated with the simulation.

9. A system (102) for simulating dynamic feedback control systems comprising:
simulation software in communication with shared memory (112), wherein the simulation software includes a simulation model (114);
at least a portion of control system logic (106) associated with a controller in communication with the shared memory, wherein the shared memory establishes a connection via a common access to at least a portion of the control system logic of the controller and the simulation software;
a database (118) in communication with the simulation software and controller, wherein a plurality of state data associated with the control system logic and the simulation model is stored in the database; and
a timing and control mechanism (116) in communication with the controller and the simulation software, wherein the timing and control mechanism synchronizes the simulation software and the at least a portion of the control system logic.

10. The system (102) of Claim 9, further comprising a graphical user interface in communication with the at least a portion of the control system logic (106) for accepting user commands configuring or executing the simulation.
